# EUROPEAN PATENT APPLICATION

(11) **EP 4 768 944 A1**
(43) Date of publication of application: **01.07.2026**
(21) Application number: 25827250.9
(22) Date of filing: 21.04.2025
(51) Int. Cl.: G01R 31/382, G01R 31/36, G01R 31/371, H02J 7/00

(54) **BATTERY STATE MANAGEMENT DEVICE AND METHOD THEREOF**

(30) Priority: 24.06.2024 KR 20240082024
(71) Applicant: LG Energy Solution, Ltd., Seoul 07335 (KR)
(72) Inventor: KIM, Sang Yeon, Daejeon 34122 (KR); CHOI, Jang Hyeok, Daejeon 34122 (KR); LEE, Jae Won, Daejeon 34122 (KR)
(74) Representative: Plasseraud IP
(86) International application number: PCT/KR2025/005356
(87) International publication number: WO 2026/005239

(57) **Abstract**

A battery state management device according to an embodiment of this document includes a first sensor configured to be constantly supplied with power through a first power supply circuit and to detect a state of a battery unit, a switch configured to electrically connect a second power supply circuit that supplies power to a second sensor different from the first sensor to the first power supply circuit, and a power control circuit configured to control an operation of the switch in response to an abnormal signal corresponding to a detection result of the first sensor.

## Description

### TECHNICAL FIELD

### Cross-reference to Related Applications

This application claims priority from Korean Patent Application No. 10-2024-0082024, filed on June 24, 2024, the disclosures of which are incorporated by reference herein.

### Technical Field

Embodiments disclosed in this document relate to a battery state management device and a management method thereof.

### BACKGROUND ART

Recently, research and development on secondary batteries have been actively conducted. Here, secondary batteries are batteries that can be charged and discharged, and may be interpreted as including both conventional Ni/Cd batteries, Ni/MH batteries, and recent lithium-ion batteries. Recently, the scope of use of the secondary batteries has expanded to include a power source for electric vehicles, and the secondary batteries are attracting attention as a next-generation energy storage medium.

Due to the Fourth Industrial Revolution, as high-capacity, high-output batteries are required in various industrial fields, the importance of technology for monitoring abnormalities of battery units is increasing. Identifying abnormalities of battery units through monitoring is essential not only for securing battery stability but also for securing user confidence. Accordingly, efforts are being made to increase the accuracy of monitoring. However, if excessive time and electrical resources are allocated to monitoring whether there is an abnormality, battery output may be degraded, which may result in degradation of battery performance. Accordingly, technology development is being conducted to perform monitoring whether there is an abnormality with limited time and electrical resources.

### DISCLOSURE OF THE INVENTION

### TECHNICAL PROBLEM

Embodiments disclosed in this document provide a battery state management device and a management method thereof that monitor a state of a battery unit in low power mode.

Embodiments disclosed in this document provide a battery state management device and a management method thereof that are activated when an abnormality is detected in low power mode.

Embodiments disclosed in this document provide a battery state management device and a management method thereof that activate a central control device external to the battery state management device when activated in a low power mode.

Embodiments disclosed in this document provide a battery state management device and a management method thereof that reduce resources consumed for monitoring the state of the battery unit.

The technical problems of this document are not limited to the technical problems mentioned above, and other technical problems that are not mentioned may be clearly understood by those skilled in the art from the descriptions below.

### TECHNICAL SOLUTION

A battery state management device according to an embodiment of this document includes a first sensor configured to be constantly supplied with power through a first power supply circuit and to detect a state of a battery unit, a switch configured to electrically connect a second power supply circuit that supplies power to a second sensor different from the first sensor to the first power supply circuit, and a power control circuit configured to control an operation of the switch in response to an abnormal signal corresponding to a detection result of the first sensor.

According to an embodiment, the power control circuit may be configured to control the operation of the switch by providing voltage to the switch in response to obtaining the abnormal signal or obtaining an alarm signal from a central control device external to the battery state management device.

According to an embodiment, the switch may be configured to electrically connect the second power supply circuit to the first power supply circuit to supply power to the second sensor based on obtaining voltage from the power supply circuit by being electrically connected to the power control circuit.

According to an embodiment, the first power supply circuit may be configured to include at least one of an inductor-capacitor (LC) filter, a capacitor-inductor-capacitor (CLC) filter, or any combination thereof, and a first low dropout (LDO) that provides power equal to a magnitude of a rated voltage of the first sensor to the first sensor. The second power supply circuit may be configured to include a second LDO that provides power equal to a magnitude of a rated voltage of the second sensor to the second sensor.

According to an embodiment, the battery state management device may further include an activation circuit configured to transmit a signal for activating a central control device external to the battery state management device to the central control device based on the first power supply circuit and the second power supply circuit being electrically connected to each other, and one terminal of the activation circuit may be configured to be electrically connected to the central control device and the other terminal of the activation circuit may be electrically connected to the second power supply circuit.

According to an embodiment, the battery state management device may further include a micro controller unit (MCU) of which first terminal is electrically connected to the first sensor, in which a second terminal of the MCU may be electrically connected to the second sensor, a third terminal of the MCU may be electrically connected to the second power supply circuit, and a fourth terminal of the MCU may be electrically connected to the power control circuit.

According to an embodiment, the battery state management device may further include a controller area network (CAN) transceiver of which one terminal is electrically connected to the second power supply circuit, and the other terminal of the CAN transceiver may be electrically connected to the MCU.

According to an embodiment, the first sensor may be configured to be supplied with power through the first power supply circuit in a low power mode according to power less than or equal to a reference value, and the second sensor may be configured to be supplied with power in the low power mode depending on whether the first power supply circuit and the second power supply circuit are electrically connected to each other.

A battery state management method according to another embodiment of this document includes an operation of detecting, by a first sensor constantly supplied with power through a first power supply circuit, a state of a battery unit, an operation of controlling, by a power control circuit, an operation of a switch in response to an abnormal signal corresponding to a detection result of the first sensor, and an operation of electrically connecting, by the switch, a second power supply circuit that supplies power to a second sensor different from the first sensor to the first power supply circuit.

According to an embodiment, the battery state management method may further include an operation of controlling, by the power control circuit, the operation of the switch by providing voltage to the switch in response to obtaining an alarm signal from a central control device external to a battery state management device.

According to an embodiment, the operation of electrically connecting, by the switch, the second power supply circuit that supplies power to the second sensor different from the first sensor to the first power supply circuit may further include an operation of causing, by the switch, the switch to electrically connect the second power supply circuit to the first power supply circuit to supply power to the second sensor based on obtaining voltage from the power supply circuit by being electrically connected to the power control circuit.

According to an embodiment, the first power supply circuit may include at least one of an inductor-capacitor (LC) filter, a capacitor-inductor-capacitor (CLC) filter, or any combination thereof, and a first low dropout (LDO) that provides power equal to a magnitude of a rated voltage of the first sensor to the first sensor, and the second power supply circuit may include a second LDO that provides power equal to a magnitude of a rated voltage of the second sensor to the second sensor.

According to an embodiment, the battery state management method may further include an operation of transmitting, by an activation circuit, a signal for activating a central control device external to the battery state management device to the central control device based on the first power supply circuit and the second power supply circuit being electrically connected to each other, and one terminal of the activation circuit may be configured to be electrically connected to the central control device and the other terminal of the activation circuit may be electrically connected to the second power supply circuit.

According to an embodiment, the battery state management method may further include an operation of transmitting, by a micro controller unit (MCU), at least one of a measurement value of the first sensor, a measurement value of the second sensor, or any combination thereof to a controller area network (CAN) transceiver. A first terminal of the MCU may be electrically connected to the first sensor, a second terminal of the MCU may be electrically connected to the second sensor, a third terminal of the MCU may be electrically connected to the second power supply circuit, and a fourth terminal of the MCU may be electrically connected to the power control circuit.

According to an embodiment, the battery state management method may further include an operation of identifying, by the CAN transceiver, at least one of the measurement value of the first sensor, the measurement value of the second sensor, or any combination thereof. One terminal of the CAN transceiver may be electrically connected to the second power supply circuit and the other terminal of the CAN transceiver may be electrically connected to the MCU.

According to an embodiment, the first sensor may be configured to be supplied with power through a first power supply circuit in a low power mode according to power less than or equal to a reference value, and the second sensor may be configured to be supplied with power in the low power mode depending on whether the first power supply circuit and the second power supply circuit are electrically connected to each other.

### ADVANTAGEOUS EFFECTS

This technology can monitor the state of the battery unit in low power mode.

In addition, this technology can activate the battery state management device when an abnormality is detected in the low power mode.

In addition, this technology can activate the central control device external to the battery state management device when activated in the low power mode.

In addition, this technology can reduce the resources consumed for monitoring the state of the battery unit.

In addition, a variety of effects can be provided that are identified directly or indirectly through this document.

### BRIEF DESCRIPTION OF THE DRAWINGS

FIG. 1 is a block diagram showing a battery pack, in a battery state management device and a battery state management method according to an embodiment of this document.
FIG. 2 is a block diagram showing a configuration of a battery state management device according to an embodiment of this document.
FIG. 3 is a block diagram showing a battery state management device, in a battery state management device and a battery state management method according to an embodiment of this document.
FIG. 4 is a circuit diagram showing a switch and a power control circuit, in a battery state management device and a battery state management method according to an embodiment of this document.
FIG. 5 is a circuit diagram showing an activation circuit, in a battery state management device and a battery state management method according to an embodiment of this document.
FIG. 6 shows a flow of operation of a battery state management device that operates an abnormality detection module, in a battery state management device and a battery state management method according to an embodiment of this document.
FIG. 7 shows a flow of operation of a battery state management device that electrically connects a second power supply circuit to a first power supply circuit, in a battery state management device and a battery state management method according to an embodiment of this document.
FIG. 8 is a block diagram showing a hardware configuration of a computing system that performs a battery state management method, in a battery state management device and a battery state management method according to an embodiment of this document.

### MODE FOR CARRYING OUT THE INVENTION

Hereinafter, some embodiments described in this document are described with reference to the accompanying drawings. However, this is not intended to limit this technology to a specific embodiment, but should be understood to include various modifications, equivalents, and/or alternatives of the embodiments of this technology.

When adding reference numerals to components in each drawing, it should be noted that the same components are given the same reference numerals as much as possible even if they are shown in different drawings. In addition, when describing various embodiments disclosed in this document, if a specific description of a related known configuration or function is determined to hinder understanding of the embodiments of the present disclosure, the detailed description thereof is omitted. A singular form of a noun corresponding to an item may include one item or a plurality of items unless the relevant context clearly indicates otherwise.

In describing the components of the embodiments of this document, terms such as first, second, A, B, (a), (b), etc. may be used. These terms are only intended to distinguish the components from other components, and the nature, order, or sequence of the components are not limited by the terms. In addition, unless otherwise defined, all terms used herein, including technical or scientific terms, have the same meaning as generally understood by a person having ordinary skill in the art to which the embodiments disclosed in this document belong. Terms defined in commonly used dictionaries should be interpreted as having a meaning consistent with the meaning they have in the context of the relevant technology, and shall not be interpreted in an ideal or excessively formal sense unless explicitly defined in this application.

In addition, in the present disclosure, expressions of "more than" or "less than" may be used to determine whether a specific condition is satisfied or fulfilled, but this is only a description for expressing an example and does not exclude descriptions of "greater than or equal to" or "less than or equal to". A condition described as "greater than or equal to" may be replaced with "more than", a condition described as "less than or equal to" may be replaced with "less than", and a condition described as "greater than or equal to and less than" may be replaced with "more than and less than or equal to". In addition, hereinafter, "A" to "B" mean at least one of the elements from A (including A) to B (including B).

In this document, each of phrases "A or B", "at least one of A and B", "at least one of A or B", "A, B, or C", "at least one of A, B, and C", and "at least one of A, B, or C" may include any one of the items listed together in the corresponding phrase among the phrases, or all possible combinations thereof.

In this document, when a component (e.g., a first component) is referred to as being "connected", "coupled" or "joined" to another component (e.g., a second component), with or without the terms "functionally" or "communicatively", it means that a component can be connected to another component directly (e.g., in a wired manner), wirelessly, or through a third component.

The method according to the various embodiments disclosed in this document may be provided by being included in a computer program product. The computer program product may be traded between a seller and a buyer as a product. The computer program product may be distributed in the form of a machine-readable recording medium (e.g., compact disc read only memory (CD-ROM)), or distributed through an application store, distributed directly between two user devices, or distributed online (e.g., downloaded or uploaded). In the case of online distribution, at least a part of the computer program product may be temporarily stored or tentatively generated in a machine-readable recording medium, such as a memory of a manufacturer's server, an application store's server, or a relay server.

According to various embodiments, each of the components (e.g., modules or programs) described above may include a single or plurality of entities, and some of the plurality of entities may be separated and placed in other components. According to various embodiments, one or more of the components or operations described above may be omitted, or one or more other components or operations may be added. Alternatively or additionally, a plurality of components (e.g., modules or programs) may be integrated into a single component. In such a case, the integrated component may perform one or more functions of each of the plurality of components identically or similarly to those performed by the corresponding component among the plurality of components prior to the integration. According to various embodiments, the operations performed by a module, program, or other component may be performed sequentially, in parallel, repeatedly, or heuristically, or one or more of the operations may be performed in a different order, omitted, or performed by being added with one or more other operations.

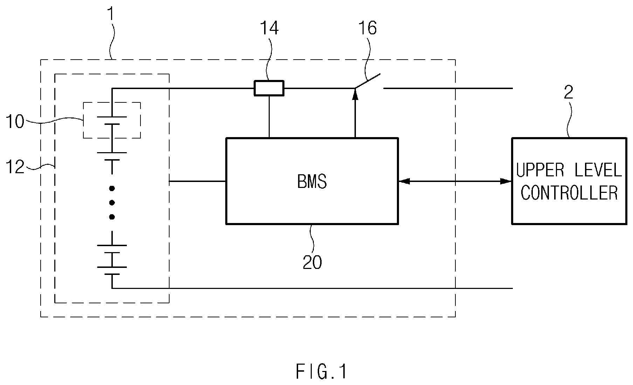

Hereinafter, embodiments of this document will be described in detail with reference to FIGS. 1 to 8.

FIG. 1 is a block diagram showing a battery pack according to an embodiment disclosed in this document.

Referring to FIG. 1, a battery pack 1 may include a battery unit 12, a sensor unit 14, a switching unit 16, and a battery management system (BMS) 20. In this case, the battery pack 1 may be provided with a plurality of battery units 12, sensor units 14, switching units 16, and battery management systems 20.

According to an embodiment, the battery unit 12 may supply power to a target device (not shown). To this end, the battery unit 12 may be electrically connected to the target device. Here, the target device may include an electrical, electronic, or mechanical device that operates by receiving power from the battery pack 1. For example, the target device may be an electric vehicle (EV), but is not limited thereto.

According to an embodiment, the battery unit 12 may include at least one battery cell 10 that can be charged and discharged. Here, the battery cell 10 may be a basic unit of a battery cell that can be used by charging and discharging electric energy. For example, the battery cell 10 may be a lithium-ion (Li-ion) battery, a lithium-ion polymer (Li-ion polymer) battery, a nickel-cadmium (Ni-Cd) battery, a nickel-metal hydride (Ni-MH) battery, etc., but is not limited thereto.

According to an embodiment, a plurality of battery units 12 may be connected in series or in parallel. For example, the battery unit 12 may be a battery module, a battery bank, or a set of battery cells (cell-to-pack structure).

According to an embodiment, the sensor unit 14 may obtain information related to the battery unit 12. According to an embodiment, the sensor unit 14 may obtain values (or information) related to a state of each of the battery units 12 and battery cells 10. In an embodiment, the values related to the state may include one or more values for voltage, current, resistance, state of charge (SOC), state of health (SOH), or temperature of the battery cell, or a combination thereof.

According to an embodiment, the sensor unit 14 may provide information on each of a plurality of battery units 12 to the battery management system 20.

According to an embodiment, the switching unit 16 may include a device for controlling a current flow for charging or discharging the battery unit 12. For example, the switching unit 16 may include at least one relay and/or magnetic contactor, etc., depending on the specifications of the battery pack 1.

According to an embodiment, the battery management system (BMS) 20 may control or manage the battery pack 1 to prevent overcharge and overdischarge by monitoring the voltage, current, temperature, etc. of the battery pack 1. For example, the battery management system 20 is an interface that receives values obtained by measuring various parameters described above, and may include a plurality of terminals, a circuit connected to these terminals to process the received values, etc. In addition, the battery management system 20 may control the sensor unit 14 and/or the switching unit 16. For example, the battery management system 20 may be connected to the plurality of battery units 12 to monitor the state of each of the plurality of battery units 12 and control ON/OFF of a relay or a contactor.

According to an embodiment, an operation of the battery management system 20 may be performed by the battery management system (BMS) in a vehicle, and may also be performed in various devices such as a server, a cloud, a charger, or a charger/discharger.

An upper level controller 2 may transmit a control signal for the plurality of battery units 12 to the battery management system 20. Accordingly, the operation of the battery management system 20 may be controlled based on the signal applied from the upper level controller 2.

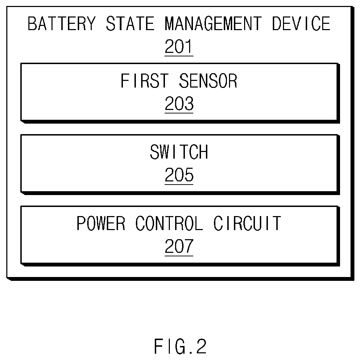

According to an embodiment, the battery management system 20 may include a battery state management device 201 of FIG. 2. According to another embodiment, the battery management system 20 may be a different system from the battery state management device 201 of FIG. 2. That is, the battery state management device 201 of FIG. 2 may be included in the battery pack 1 or may be configured as another device external to the battery pack 1. Hereinafter, for convenience of description, the description will be made on the assumption that the battery state management device 201 is composed of another device external to the battery pack 1. In addition, the operation of the battery state management device 201 below may be performed by a battery management system (BMS) in the vehicle, as well as by various devices such as a server, a cloud, a charger, or a charger/discharger.

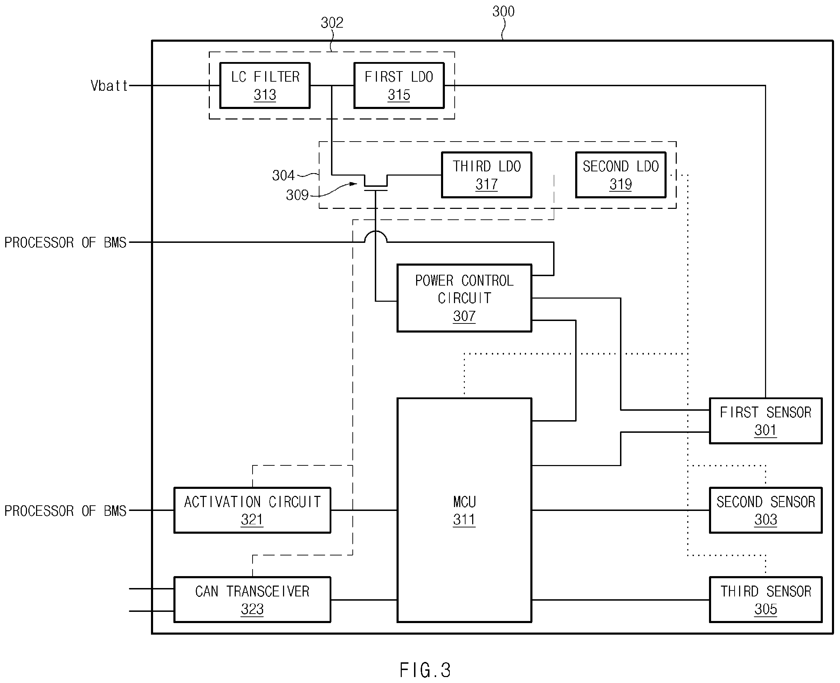

FIG. 2 is a block diagram showing a configuration of a battery state management device according to an embodiment of this document. FIG. 3 is a block diagram showing a battery state management device, in a battery state management device and a battery state management method according to an embodiment of this document.

Referring to FIGS. 2 and 3, battery state management devices 201 and 300 may include first sensors 203 and 301, switches 205 and 309, and power control circuits 207 and 307.

The first sensors 203 and 301, a second sensor 303, and a third sensor 305 may obtain a measurement value indicating a state of the battery unit. A first power supply circuit 302 that supplies power to the first sensors 203 and 301 may include an LC filter 313 and a first low dropout (LDO) 315. A second power supply circuit 304 that supplies power to the second sensor 303, the third sensor 305, and a micro controller unit (MCU) 311 may include a third LDO 317 and a second LDO 319. An activation circuit 321 or a controller area network (CAN) transceiver 323 may be electrically connected to the second power supply circuit 304 and an MCU 311.

According to an embodiment, the battery state management devices 201 and 300 may be set to a low power mode according to power less than or equal to a reference value in a designated situation where power exceeding the reference value is not required (e.g., a situation in which a vehicle including a battery is parked, or an engine of a vehicle including a battery is turned off). Since an output power exceeding the reference value is not required in the low power mode, the battery state management devices 201 and 300 may reduce power consumption of the battery state management device 201 and 300, so that the power efficiency of the battery is increased.

According to an embodiment, the battery state management devices 201 and 300 may need to monitor whether the battery is abnormal (e.g., whether there is thermal runaway and whether there is a collision) for safety even in the low power mode. However, since monitoring whether the battery is abnormal also requires power, the battery state management devices 201 and 300 may reduce the power consumed for monitoring for power efficiency.

According to an embodiment, in the low power mode, for power efficiency, the first power supply circuit 302 supplies power to the first sensors 203 and 301, and the switches 205 and 309 that electrically connect the second power supply circuit 304 that supplies power to the second sensor 303 and the first power supply circuit 302 may be deactivated. Since the second sensor 303 is supplied with power through the second power supply circuit 304, the second sensor 303 cannot be supplied with power when the first power supply circuit 302 and the second power supply circuit 304 are not electrically connected to each other. In other words, in the low power mode, for power efficiency, the first sensors 203 and 301 may be supplied with power, and the second sensor 303 may not be supplied with power.

According to an embodiment, the first sensors 203 and 301 may include a pressure sensor that measures the pressure of a battery unit (e.g., a battery cell, a battery module, a battery pack, and a battery), but the embodiment of this document may not be limited thereto. According to an embodiment, the second sensor 303 or the third sensor 305 may include a gas sensor that detects whether a gas leak occurs, or a three-axis sensor that detects the degree of movement of the battery, but the embodiment of this document may not be limited thereto.

According to an embodiment, in the low power mode, for power efficiency, based on the fact that an alarm signal transmitted from a central control device (e.g., the MCU of the BMS) external to the battery state management devices 201 and 300 is transmitted to the power control circuits 207 and 307, or an abnormal signal corresponding to a detection result (e.g., pressure of battery unit) of the first sensors 203 and 301 is transmitted from the first sensors 203 and 301 to the power control circuits 207 and 307, the switches 205 and 309 may electrically connect the first power supply circuit 302 and the second power supply circuit 304. The alarm signal and the abnormal signal will be described below with reference to FIG. 3.

According to an embodiment, when the battery state management devices 201 and 300 are in the low power mode, all other components except the first sensors 203 and 301 and the first power supply circuit 302 may be deactivated. According to an embodiment, the first power supply circuit 302 may include a capacitor-inductor-capacitor (CLC) filter instead of an inductor-capacitor (LC) filter 313. According to an embodiment, a first LDO 315 may adjust a voltage Vbatt of the power provided from the battery to power equal to a magnitude of a rated voltage magnitude of the first sensors 203 and 301 and then provide the power to the first sensors 203 and 301.

According to an embodiment, the first sensors 203 and 301 may monitor whether the battery unit is abnormal. When the first sensor 203 and 301 detect an abnormality in the battery unit, the first sensors 203 and 301 may transmit an abnormality signal to the power control circuits 207 and 307.

According to an embodiment, the power control circuits 207 and 307 may provide voltage to the switches 205 and 309 based on obtaining an alarm signal from a central control device external to the battery state management devices 201 and 300 or obtaining an abnormality signal from the first sensors 203 and 301. The switches 205 and 309 may electrically connect the first power supply circuit 302 and the second power supply circuit 304 to each other based on obtaining the voltage to supply power to the second sensor 303, the third sensor 305, the activation circuit 321, the CAN transceiver 323, and the MCU 311. The switches 205 and 309 may be referred to as a metal oxide semiconductor field effect transistor (MOSFET) switch, but the embodiment of this document may not be limited thereto.

According to an embodiment, the second LDO 319 may adjust the voltage of power provided from the battery to power equal to a magnitude of the rated voltage of the second sensor 303 or the third sensor 305, and then provide the power to a sensor (e.g., the second sensor 303 or the third sensor 305) corresponding to the rated voltage magnitude.

According to an embodiment, the third LDO 317 may adjust the voltage Vbatt of the power provided from the battery to power equal to a magnitude of a voltage requested by a circuit including the activation circuit 321 or the CAN transceiver 323, and then provide the power to the circuit corresponding to the requested voltage magnitude (e.g., the circuit including the activation circuit 321 or CAN transceiver 323).

According to an embodiment, when the first power supply circuit 302 and the second power supply circuit 304 are electrically connected to each other through the switches 205 and 309 based on an abnormal signal of the first sensors 203 and 301, in order to cope with an abnormality in the battery unit, the activation circuit 321 may transmit an activation signal for activating a central control unit external to the battery state management devices 201 and 300 from the battery state management devices 201 and 300 to the central control device (e.g., the MCU of the BMS) external to the battery state management devices 201 and 300. The central control device external to the battery state management devices 201 and 300 may be activated based on the received activation signal. One terminal of the activation circuit 321 may be electrically connected to the central control unit external to the battery state management devices 201 and 300. Another terminal of the activation circuit 321 may be electrically connected to the second power supply circuit 304. Still another terminal of the activation circuit 321 may be electrically connected to the MCU 311.

According to an embodiment, when the first power supply circuit 302 and the second power supply circuit 304 are electrically connected to each other through the switches 205 and 309 by an abnormal signal of the first sensors 203 and 301, the MCU 311 may obtain at least one measurement value obtained from the sensor (e.g., the first sensor 203, 301, the second sensor 303, and the third sensor 305) included in the battery state management devices 201 and 300 to determine the state of the battery unit. The MCU 311 may transmit at least one measurement value to the CAN transceiver 323. The CAN transceiver 323 may transmit at least one measurement value obtained from the sensor to an external element (e.g., a central control device) of the battery state management devices 201 and 300. One terminal of the CAN transceiver 323 may be electrically connected to the second power supply circuit 304. The other terminal of the CAN transceiver 323 may be electrically connected to the MCU 311. A first terminal of the MCU 311 may be electrically connected to the first sensors 203 and 301, a second terminal of the MCU 311 may be electrically connected to the second sensor 303, a third terminal of the MCU 311 may be electrically connected to the second power supply circuit 304, and a fourth terminal of the MCU 311 may be electrically connected to the power control circuits 207 and 307.

According to an embodiment, in a situation where the central control device external to the battery state management devices 201 and 300 is activated (e.g., a situation where the vehicle engine is turned on and the MCU of the BMS is turned on), the power control circuits 207 and 307 may obtain an alarm signal from the central control device external to the battery state management devices 201 and 300.

According to an embodiment, when an alarm signal is obtained from a central control device external to the battery state management devices 201 and 300, the power control circuits 207 and 307 may electrically connect the first power supply circuit 302 and the second power supply circuit 304 to each other by providing voltage to the switches 205 and 309.

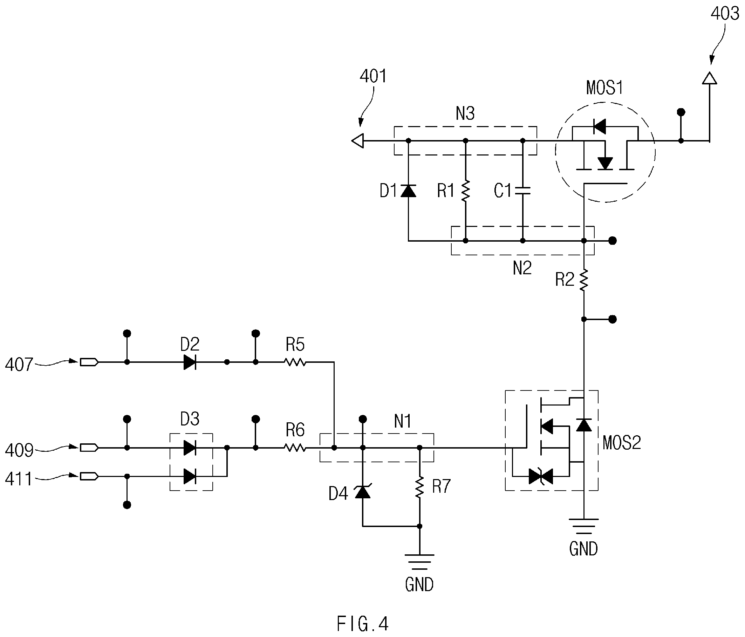

FIG. 4 is a circuit diagram showing a switch and a power control circuit in a battery state management device and a battery state management method according to an embodiment of this document.

Referring to FIG. 4, a first terminal 401 may be electrically connected to the first power supply circuit 302.

A second terminal 403 may be electrically connected to the second power supply circuit 304. A third terminal 407 may be electrically connected to the central control device external to the battery state management device 201.

The third terminal 407 may receive an alarm signal from the central control device external to the battery state management device 201.

A fourth terminal 409 may be electrically connected to the first sensor 203. The fourth terminal 409 may receive the abnormal signal from the first sensor 203.

A fifth terminal 411 may be electrically connected to the MCU 311. The fifth terminal 411 may receive a signal indicating that power is supplied to the MCU 311 of the battery state management device 201 from the MCU 311.

According to an embodiment, when the signal indicating that power is supplied to the MCU 311 of the battery state management device 201 is obtained from the fifth terminal 411, a switch (e.g., a switch 205, a first switch MOS 2, and a second switch MOS 1) may electrically connect the first terminal 401 and the second terminal 403 even if an alarm signal is not continuously obtained from the third terminal 407 or an abnormal signal signal is not continuously obtained from the fourth terminal 409.

According to an embodiment, the third terminal 407 may be electrically connected to a first diode D2. The first diode D2 may be electrically connected to the third terminal 407 and a first resistor R5. The first resistor R5 may be electrically connected to the third terminal 407 and a first node N1.

According to an embodiment, the fourth terminal 409 may be electrically connected to a second diode D3. The second diode D3 may be electrically connected to the fourth terminal 409, the fifth terminal 411, and a second resistor R6. Although the second diode D3 is illustrated as being simultaneously connected to the fourth terminal 409 and the fifth terminal 411, the embodiment of this document may not be limited thereto. According to an embodiment, the fourth terminal 409 may be connected to the second diode D3 connected to the second resistor R6, and the fifth terminal 411 may be electrically connected to another diode (not illustrated) connected to the second resistor R6. The second resistor R6 may be electrically connected to the second diode D3 and the first node N1.

According to an embodiment, the first node N1 may be electrically connected to the first resistor R5, the second resistor R6, a third diode D4, a third resistor R7, and the first switch MOS 2. The first switch MOS 2 may represent an N-type MOSFET switch that connects a source terminal and a drain terminal when a voltage greater than a threshold voltage is applied to a gate terminal. The third diode D4 may be electrically connected to the first node N1, the third resistor R7, and the ground. The third resistor R7 may be electrically connected to the first node N1, the third diode D4, and the ground.

According to an embodiment, the first switch MOS 2 may be electrically connected to the ground and a fourth resistor R2. The fourth resistor R2 may be electrically connected to a second node N2 and the first switch MOS 2.

According to an embodiment, the second node N2 may be electrically connected to the third diode D1, the fifth resistor R1, the first capacitor C1, a second switch MOS 1, and the fourth resistor R2. The second switch MOS 1 may represent a P-type MOSFET switch that connects a source terminal and a drain terminal when a voltage less than the threshold voltage is applied to the gate terminal.

According to an embodiment, the third diode D1 may be electrically connected to a third node N3 and the second node N2. The fifth resistor R1 may be electrically connected to the third node N3 and the second node N2. The first capacitor C1 may be electrically connected to the third node N3 and the second node N2. The second switch MOS 1 may be electrically connected to the third node N3, the second node N2, and the second terminal 403.

According to an embodiment, the third node N3 may be electrically connected to the first terminal 401, the third diode D1, the fifth resistor R1, the first capacitor C1, and the first switch MOS 1.

According to an embodiment, the second switch MOS 1 may be electrically connected to the third node N3, the second node N2, and the second terminal 403.

According to an embodiment, the first switch MOS 2 may be activated based on obtaining an alarm signal from the third terminal 407 or obtaining an abnormal signal from the fourth terminal 409. The alarm signal may be transmitted as a voltage signal according to a voltage of a designated first magnitude (e.g., approximately 5 V). The abnormal signal may be transmitted as a voltage signal according to a voltage of a designated second magnitude (e.g., approximately 3.3 V). A signal indicating that power is supplied to the MCU 311 of the battery state management device 201 may be transmitted as a signal according to the voltage of the designated third magnitude (e.g., approximately 3.3 V).

For example, an alarm signal (voltage signal) obtained from the third terminal 407 may be applied to the first switch MOS 2 from the central control device external to the battery state management device 201 according to the first diode D2 and the first resistor R5. The first diode D2 may reduce the current flowing in the direction from the first resistor R5 to the external central control device. The first resistor R5 may reduce the overvoltage from being applied to the first switch MOS 2.

For example, an abnormal signal (voltage signal) obtained from the fourth terminal 409 or a signal (voltage signal) indicating that power is supplied to the MCU 311 of the battery state management device 201 obtained from the fifth terminal 411 may be applied to the first switch MOS 2 according to the second diode D3 and the second resistor R6. The second diode D3 may reduce the frequency of the case in which a current flows from the second resistor R6 to the first sensor 203 or the MCU 311. The second resistor R6 may reduce the frequency of the case in which an overvoltage is applied to the first switch MOS 2.

According to an embodiment, the third diode D4 may reduce the current flowing in the direction from the ground to the first node N1. The third resistor R7 may reduce the frequency of the case in which the first switch MOS 2 is turned on due to a noise signal. The first capacitor C1 may be disposed to protect the second switch MOS 1.

The first diode D2 may reduce the current flowing in a direction from the first resistor R5 to the external central control device. Since the first resistor R7 is connected to the ground, even if a noise signal is applied from the third terminal 407 to the fifth terminal 411, the voltage applied to the first switch MOS 2 may be maintained to be less than or equal to the voltage reference value (e.g., approximately 1.6 V) through voltage distribution.

According to an embodiment, when a signal (voltage signal) is applied from the third terminal 407 or the fourth terminal 409 and a voltage greater than or equal to the voltage reference value is applied to a gate terminal of the first switch MOS 2, the first switch MOS 2 may be activated. When the first switch MOS 2 is activated, the first switch MOS 2 may electrically connect the fourth resistor R2 to the ground.

According to an embodiment, when the first switch MOS 2 is activated, the voltage applied from the first terminal 401 may be distributed by the fifth resistor R1 and the fourth resistor R2. A voltage equal to a magnitude of the voltage applied to the fifth resistor R1 may be applied to the second switch MOS 1.

According to an embodiment, the third diode D1 may reduce the frequency of the case where a current flows in the direction from the second node N2 to the third node N3.

When the first switch MOS 2 is activated, the first terminal 401 and the second terminal 403 may be electrically connected to each other based on the voltage less than a threshold voltage being applied to a gate terminal of the second switch MOS 1.

When the first switch MOS 2 is deactivated, the electrical connection between the first terminal 401 and the second terminal 403 may be deactivated based on the voltage greater than the threshold voltage being applied to the gate terminal of the second switch MOS 1.

According to an embodiment, the first terminal 401 and the second terminal 403 are electrically connected to each other, so that the first power supply circuit 302 and the second power supply circuit 304 may be electrically connected to each other. When the first power supply circuit 302 and the second power supply circuit 304 are electrically connected to each other, the MCU 311 may be activated. When the MCU 311 is activated, a signal indicating that power is supplied to the MCU 311 of the battery state management device 201 may be input to the fifth terminal 411. When the fifth terminal 411 receives a signal indicating that power is supplied to the MCU 311 of the battery state management device 201, the electrical connection between the first terminal 401 and the second terminal 403 may be maintained even if the alarm signal is not continuously obtained from the third terminal 407 or the abnormal signal is not continuously obtained from the fourth terminal 409.

According to an embodiment, when the fifth terminal 411 does not receive a signal indicating that power is supplied to the MCU 311 of the battery state management device 201 and the input of the alarm signal or abnormal signal thereto is stopped, the second switch MOS 1 may deactivate the electrical connection between the first terminal 401 and the second terminal 403.

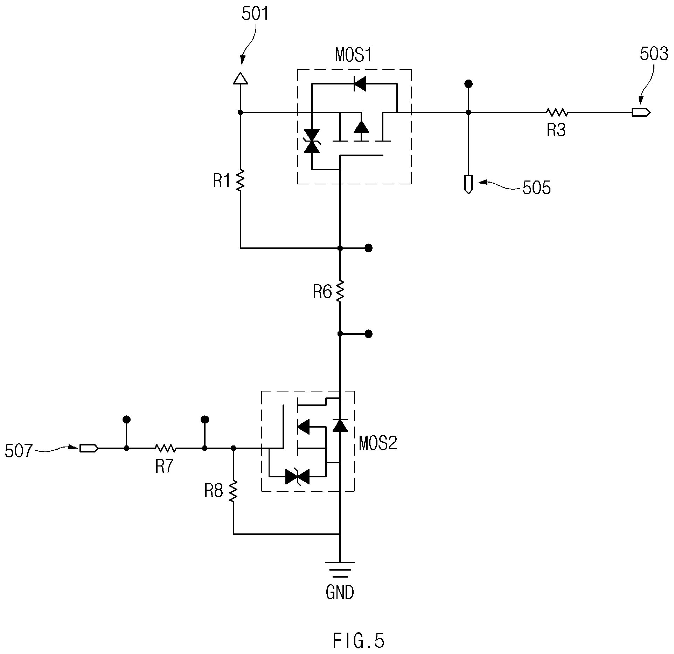

FIG. 5 is a circuit diagram showing an activation circuit, in a battery state management device and a battery state management method according to an embodiment of this document.

Referring to FIG. 5, a first terminal 501 may be electrically connected to the second power supply circuit 304. A second terminal 503 may be electrically connected to the central control device external to the battery state management device 201. A third terminal 505 and a fourth terminal 507 may be electrically connected to the MCU 311.

The activation circuit may transmit a signal for activating a central control device external to the battery state management device 201 to the central control device based on the battery state management device 201 being activated as a whole by electrically connecting the first power supply circuit 302 and the second power supply circuit 304 to each other.

The first switch MOS 2 may represent an N-type MOSFET switch that connects the source terminal and the drain terminal thereof when a voltage greater than the threshold voltage is applied to the gate terminal thereof. The second switch MOS 1 may represent a P-type MOSFET switch that connects the source terminal and the drain terminal thereof when a voltage less than the threshold voltage is applied to the gate terminal thereof.

According to an embodiment, the fourth terminal 507 may be electrically connected to a first resistor R7. The first resistor R7 may be electrically connected to the fourth terminal 507, a second resistor R8, and the first switch MOS 2. The first switch MOS 2 may be electrically connected to the second resistor R8, a third resistor R6, and the ground. The third resistor R6 may be electrically connected to the first switch MOS 2, a fourth resistor R1, and the second switch MOS 1. The fourth resistor R1 may be electrically connected to the first terminal 501, the second switch MOS 1, and the third resistor R6. The first terminal 501 may be electrically connected to the fourth resistor R1, and the second switch MOS 1. The second switch MOS 1 may be electrically connected to the first terminal 501, the fourth resistor R1, the third resistor R6, and a fifth resistor R3. The fifth resistor R3 may be electrically connected to the second terminal 503, and the third terminal 505. The second terminal 503 may be electrically connected to the fifth resistor R3. The third terminal 505 may be electrically connected to the fifth resistor R3 and the second switch MOS 1.

According to an embodiment, when the first power supply circuit 302 and the second power supply circuit 304 are electrically connected to each other, a voltage may be applied to the first terminal 501. However, since the first switch MOS 2 is deactivated and a voltage greater than or equal to the threshold voltage is provided to the second switch MOS 1, the first terminal 501 and the second terminal 503 may not be electrically connected to each other.

According to an embodiment, when the first power supply circuit 302 and the second power supply circuit 304 are electrically connected to each other, the fourth terminal 507 may obtain a signal indicating that the MCU 311 is activated from the MCU 311.

According to an embodiment, the first resistor R7 may protect the first switch MOS 2 when an overcurrent flows. A voltage equal to a magnitude of the voltage applied to the second resistor R8 may be applied to the first switch MOS 2.

According to an embodiment, the signal indicating that the MCU 311 is activated obtained from the third terminal 507 may activate the first switch MOS 2 by applying a voltage greater than the threshold voltage to the first switch MOS 2. When the first switch MOS 2 is activated, the third resistor R6 and the ground may be electrically connected.

When the third resistor R6 and the ground are electrically connected to each other, the voltage distributed by the fourth resistor R1 and the third resistor R6 may be applied to the second switch MOS 1.

When the third resistor R6 and the ground are not electrically connected, since the voltage applied to the second switch MOS 1 is greater than or equal to the threshold voltage value, the second switch MOS 1 may not be activated. When the third resistor R6 and the ground are electrically connected, since the voltage applied to the second switch MOS 1 is less than the threshold voltage value, the second switch MOS 1 may be activated.

According to an embodiment, the second switch MOS 1 may be activated to electrically connect the first terminal 501 and the second terminal 503 to each other.

According to an embodiment, the second terminal 503 may provide a signal for activating the central control device external to the battery state management device 201 to the central control device external to the battery state management device 201. The fifth resistor R3 may reduce the frequency of the case in which an overcurrent flows to the external central control device.

According to an embodiment, the third terminal 505 may transmit a signal indicating that the activation circuit 321 has output a signal for activating the central control device external to the battery state management device 201 to the MCU 311.

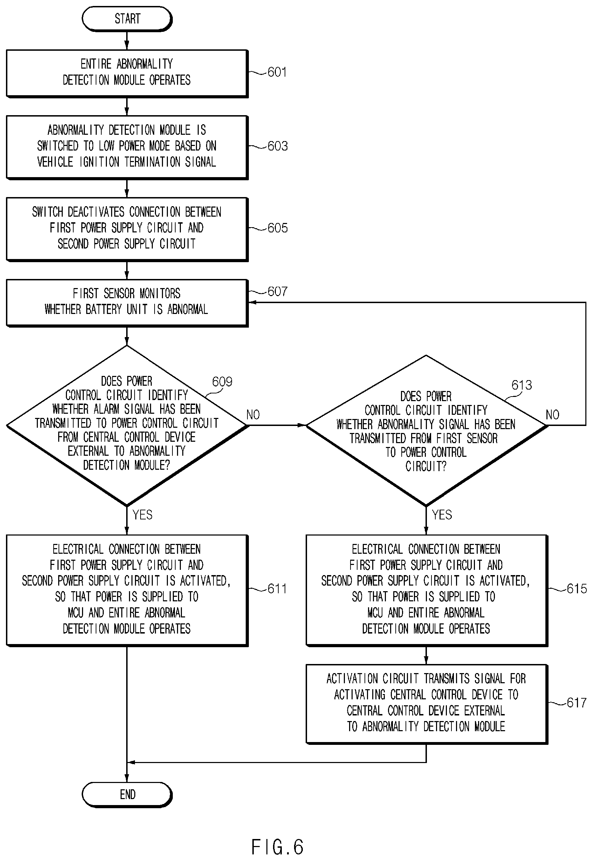

FIG. 6 illustrates the flow of operation of a battery state management device that operates an abnormality detection module included in the battery state management device, in the battery state management device and the battery state management method according to an embodiment of this document.

Referring to FIG. 6, in a first operation 601, the entire abnormality detection module according to an embodiment may operate.

According to an embodiment, the abnormality detection module may be included in the battery state management device 201 and may represent a module that monitors a state of the battery unit. The abnormality detection module may include the first power supply circuit 302, the second power supply circuit 304, the first sensors 203 and 301, the second sensor 303, the power control circuits 207 and 307, the MCU 311, the activation circuit 321, and the CAN transceiver 323.

In a second operation 603, according to an embodiment, the abnormality detection module may be switched to a low power mode based on a vehicle ignition termination signal.

In a third operation 605, according to an embodiment, the switch 205 may deactivate an electrical connection between the first power supply circuit 302 and the second power supply circuit 304.

According to an embodiment, the electrical connection between the first power supply circuit 302 and the second power supply circuit 304 may be deactivated by deactivating the switch 205 for power efficiency.

In a fourth operation 607, the first sensor 203 according to an embodiment may monitor whether the battery unit is abnormal.

According to an embodiment, the first sensor 203 may include a pressure sensor that measures the pressure of the battery unit.

In a fifth operation 609, the power control circuit 207 according to an embodiment may identify whether an alarm signal has been transmitted to the power control circuit 207 from the central control device external to the abnormality detection module. When the alarm signal has been transmitted to the power control circuit 207 from the central control device external to the abnormality detection module, the MCU 311 and the abnormality detection module may perform a sixth operation 611. When the alarm signal is not transmitted to the power control circuit 207 from the central control device external to the abnormal detection module, the power control circuit 207 may perform a seventh operation 613.

In the sixth operation 611, the electrical connection between the first power supply circuit 302 and the second power supply circuit 304 according to an embodiment is activated, so that power is supplied to the MCU 311 and the entire abnormal detection module may operate.

According to an embodiment, the power control circuit 207 may activate the switch 205 by providing voltage to the switch 205. By activating the switch 205, the first power supply circuit 302 and the second power supply circuit 304 may be electrically connected to each other. The first power supply circuit 302 and the second power supply circuit 304 are electrically connected to each other, so that the entire abnormality detection module may operate.

In the seventh operation 613, the power control circuit 207 according to an embodiment may identify whether an abnormality signal has been transmitted from the first sensor 203 to the power control circuit 207. When the abnormal signal is transmitted from the first sensor 203 to the power control circuit 207, the first power supply circuit 302 and the second power supply circuit 304 may perform an eighth operation 615. When an abnormal signal is not transmitted from the first sensor 203 to the power control circuit 207, the first sensor 203 may perform the fourth operation 607.

According to an embodiment, an abnormal signal may be transmitted from the first sensor 203 to the power control circuit 207 when an abnormality in the battery unit is identified based on measurement values obtained from the first sensor 203.

In the eighth operation 615, the electrical connection between the first power supply circuit 302 and the second power supply circuit 304 according to an embodiment is activated, so that power is supplied to the MCU 311 and the entire abnormality detection module may operate.

In a ninth operation 617, the activation circuit 321 according to an embodiment may transmit a signal for activating the central control device external to the abnormality detection module to the central control device.

According to an embodiment, the activation circuit 321 may transmit a signal for activating the central control device to the central control device to activate the central control device external to the battery state management device 201 to analyze the abnormality in the battery unit and cope with the abnormality in the battery unit. This is because when the abnormality signal is transmitted from the first sensor 203, the central control device outside the abnormality detection module is highly likely to be deactivated.

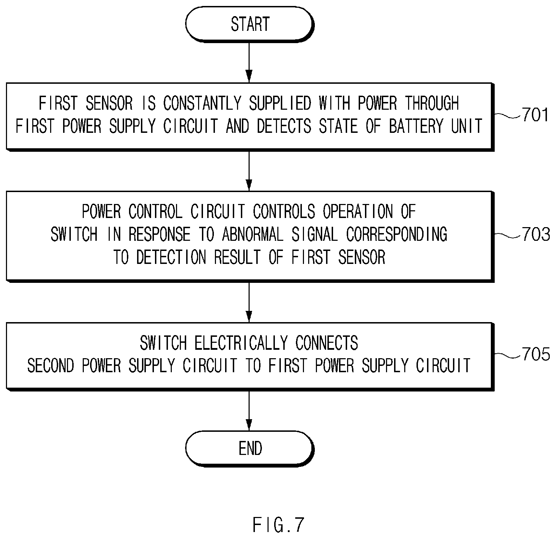

FIG. 7 illustrates the flow of operation of a battery state management device electrically connecting the second power supply circuit 304 to the first power supply circuit 302, in a battery state management device and a battery state management method according to an embodiment of this document.

Referring to FIG. 7, in a first operation 701, the first sensor 203 according to an embodiment may be constantly supplied with power through the first power supply circuit 302 and detect a state of the battery unit.

In a second operation 703, the power control circuit 207 may control the operation of the switch 205 in response to an abnormal signal corresponding to a detection result of the first sensor 203.

In a third operation 705, the switch 205 may electrically connect the second power supply circuit 304 to the first power supply circuit 302.

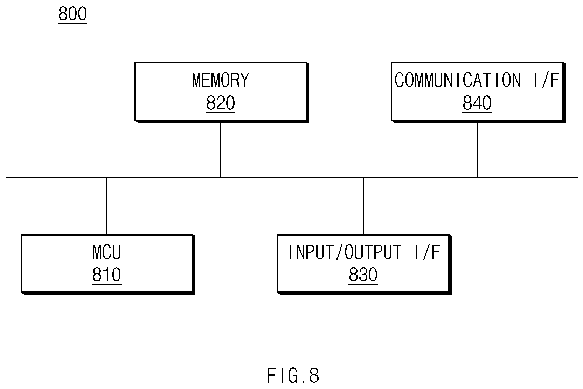

FIG. 8 is a block diagram showing a hardware configuration of a computing system that performs a battery state management method, in a battery state management device and a battery state management method according to an embodiment of this document.

Referring to FIG. 8, a computing system 800 according to an embodiment disclosed in this document may include an MCU 810, a memory 820, an input/output I/F 830, and a communication I/F 840.

The MCU 810 may be one or more processors that executes various programs (e.g., battery cell data collection program, graph generation program, data analysis program, data decomposition algorithm, normalization program, and battery cell diagnosis program, etc.) stored in the memory 820, processes various information including battery cell characteristic data, latent variables, etc. through these programs, and performs the functions of the battery state management device 201 shown in FIGS. 1 to 8 described above.

The memory 820 may store various programs such as the battery cell data collection program, the graph generation program, the data analysis program, the data decomposition algorithm, the normalization program, and the battery cell diagnosis program.

A plurality of such memories 820 may be provided as needed. The memory 820 may be a volatile memory or a nonvolatile memory. The memory 820 used as the volatile memory may be RAM, DRAM, SRAM, etc. The memory 820 used as the nonvolatile memory may be ROM, PROM, EAROM, EPROM, EEPROM, flash memory, etc. The examples of the memories 820 listed above are only examples and are not limited to these examples.

The input/output I/F 830 may provide an interface that allows data to be transmitted and received by connecting an input device (not shown) such as a keyboard, mouse, or touch panel and an output device (not shown) such as a display with the MCU 810.

The communication I/F 840 is a configuration that can transmit and receive various data with the server, and may be various devices that can support wired or wireless communication. For example, the battery state management device 201 may transmit and receive various information including shape models of battery cells, etc. to and from a separately provided external server through the communication I/F 840.

In this way, the computer program according to an embodiment disclosed in this document may be implemented as a module that performs, for example, each function shown in FIG. 2, by being recorded in the memory 820 and processed by the MCU 810.

In the above, even though all the components constituting the embodiments disclosed in this document have been described as being combined as one or operating in combination, the embodiments disclosed in this document are not necessarily limited to such embodiments. That is, within the scope of the purpose of the embodiments disclosed in this document, all of the components may be selectively combined and operated in one or more combinations.

In addition, the terms "include," "configure," or "have" described above, unless specifically stated to the contrary, mean that the corresponding component may be included, and therefore should be interpreted as being able to further include other components rather than excluding other components. All terms including technical or scientific terms have the same meaning as commonly understood by a person skilled in the art to which the embodiments disclosed in this document belong, unless otherwise defined. Terms commonly used, such as terms defined in the dictionary, should be interpreted as being consistent with the contextual meaning of the relevant technology, and should not be interpreted in an idealized or overly formal sense unless clearly defined in this document.

The above-mentioned disclosure outlines the features of several embodiments so that those skilled in the art may better understand aspects of the present disclosure. Those skilled in the art will understand that the present disclosure may be easily used as a basis for designing or changing different structures to perform the same purpose or achieve the same advantages of embodiments introduced in this document. Furthermore, those skilled in the art will recognize that such equivalent configurations do not depart from the scope of the present disclosure, and that various changes, substitutions, and modifications may be made in this specification without departing from the scope of the present disclosure.

## Claims

1. A battery state management device comprising:
a first sensor configured to be constantly supplied with power through a first power supply circuit and to detect a state of a battery unit;
a switch configured to electrically connect a second power supply circuit that supplies power to a second sensor different from the first sensor to the first power supply circuit; and
a power control circuit configured to control an operation of the switch in response to an abnormal signal corresponding to a detection result of the first sensor.

2. The battery state management device of claim 1, wherein the power control circuit is configured to control the operation of the switch by providing voltage to the switch in response to obtaining the abnormal signal or obtaining an alarm signal from a central control device external to the battery state management device.

3. The battery state management device of claim 1, wherein the switch is configured to electrically connect the second power supply circuit to the first power supply circuit to supply power to the second sensor based on obtaining voltage from the power supply circuit by being electrically connected to the power control circuit.

4. The battery state management device of claim 1, wherein the first power supply circuit is configured to include at least one of an inductor-capacitor (LC) filter, a capacitor-inductor-capacitor (CLC) filter, or any combination thereof, and a first low dropout (LDO) that provides power equal to a magnitude of a rated voltage of the first sensor to the first sensor, and
the second power supply circuit is configured to include a second LDO that provides power equal to a magnitude of a rated voltage of the second sensor to the second sensor.

5. The battery state management device of claim 1, further comprising:
an activation circuit configured to transmit a signal for activating a central control device external to the battery state management device to the central control device based on the first power supply circuit and the second power supply circuit being electrically connected to each other,
wherein one terminal of the activation circuit is configured to be electrically connected to the central control device and the other terminal of the activation circuit is electrically connected to the second power supply circuit.

6. The battery state management device of claim 1, further comprising:
a micro controller unit (MCU) of which first terminal is electrically connected to the first sensor,
wherein a second terminal of the MCU is electrically connected to the second sensor,
a third terminal of the MCU is electrically connected to the second power supply circuit, and
a fourth terminal of the MCU is electrically connected to the power control circuit.

7. The battery state management device of claim 6, further comprising:
a controller area network (CAN) transceiver of which one terminal is electrically connected to the second power supply circuit,
wherein the other terminal of the CAN transceiver may be electrically connected to the MCU.

8. The battery state management device of claim 1, wherein the first sensor is configured to be supplied with power through the first power supply circuit in a low power mode according to power less than or equal to a reference value, and
the second sensor is configured to be supplied with power in the low power mode depending on whether the first power supply circuit and the second power supply circuit are electrically connected to each other.

9. A battery state management method comprising:
an operation of detecting, by a first sensor constantly supplied with power through a first power supply circuit, a state of a battery unit;
an operation of controlling, by a power control circuit, an operation of a switch in response to an abnormal signal corresponding to a detection result of the first sensor; and
an operation of electrically connecting, by the switch, a second power supply circuit that supplies power to a second sensor different from the first sensor to the first power supply circuit.

10. The battery state management method of claim 9, further comprising:
an operation of controlling, by the power control circuit, the operation of the switch by providing voltage to the switch in response to obtaining an alarm signal from a central control device external to a battery state management device.

11. The battery state management method of claim 9, wherein the operation of electrically connecting, by the switch, the second power supply circuit that supplies power to the second sensor different from the first sensor to the first power supply circuit further includes an operation of causing, by the switch, the switch to electrically connect the second power supply circuit to the first power supply circuit to supply power to the second sensor based on obtaining voltage from the power supply circuit by being electrically connected to the power control circuit.

12. The battery state management method of claim 9, wherein the first power supply circuit is configured to include:
at least one of an inductor-capacitor (LC) filter, a capacitor-inductor-capacitor (CLC) filter, or any combination thereof; and
a first low dropout (LDO) that provides power equal to a magnitude of a rated voltage of the first sensor to the first sensor,
wherein the second power supply circuit is configured to include a second LDO that provides power equal to a magnitude of a rated voltage of the second sensor to the second sensor.

13. The battery state management method of claim 9, further comprising:
an operation of transmitting, by an activation circuit, a signal for activating a central control device external to the battery state management device to the central control device based on the first power supply circuit and the second power supply circuit being electrically connected to each other,
wherein one terminal of the activation circuit is configured to be electrically connected to the central control device and
the other terminal of the activation circuit is electrically connected to the second power supply circuit.

14. The battery state management method of claim 9, further comprising:
an operation of transmitting, by a micro controller unit (MCU), at least one of a measurement value of the first sensor, a measurement value of the second sensor, or any combination thereof to a controller area network (CAN) transceiver,
wherein a first terminal of the MCU is electrically connected to the first sensor,
a second terminal of the MCU is electrically connected to the second sensor,
a third terminal of the MCU is electrically connected to the second power supply circuit, and
a fourth terminal of the MCU is electrically connected to the power control circuit.

15. The battery state management method of claim 14, further comprising:
an operation of identifying, by the CAN transceiver, at least one of the measurement value of the first sensor, the measurement value of the second sensor, or any combination thereof,
wherein one terminal of the CAN transceiver is electrically connected to the second power supply circuit and
the other terminal of the CAN transceiver is electrically connected to the MCU.

16. The battery state management method of claim 9, wherein the first sensor is configured to be supplied with power through a first power supply circuit in a low power mode according to power less than or equal to a reference value, and
the second sensor is configured to be supplied with power in the low power mode depending on whether the first power supply circuit and the second power supply circuit are electrically connected to each other.
